# EUROPEAN PATENT APPLICATION

(11) **EP 4 679 980 A1**
(43) Date of publication of application: **14.01.2026**
(21) Application number: 25188019.1
(22) Date of filing: 08.07.2025
(51) Int. Cl.: H10F 77/14, H10F 10/14, H10F 10/165, H10F 77/30

(54) **SOLAR CELL**

(30) Priority: 10.07.2024 CN 202410917310; 09.08.2024 CN 202411097317; 09.08.2024 CN 202411095535; 29.08.2024 CN 202411209958; 29.08.2024 CN 202411205043; 29.08.2024 CN 202411204726; 29.08.2024 CN 202411204287
(71) Applicant: CSI Cells (YangZhou) Co., Ltd., Yangzhou, Jiangsu 225000 (CN)
(72) Inventor: CHEN, Haiyan, Suzhou 215000 (CN); DENG, Weiwei, Suzhou 215000 (CN)
(74) Representative: Epping - Hermann - Fischer

(57) **Abstract**

Provided is a solar cell. The solar cell includes a silicon substrate having a front surface and a back surface that face away from each other, a first doped structure disposed in the first region, a second doped structure disposed in the second region, a first electrode located at a back surface of the first doped structure, and a second electrode located at a back surface of the second doped structure. The back surface of the silicon substrate includes a first region, a second region, and an isolation region located between the first region and the second region. The back surface of the silicon substrate in the second region is recessed towards the front surface of the silicon substrate with respect to the back surface of the silicon substrate in the first region. The first doped structure is a diffusion region formed by diffusing a dopant from the back surface into the silicon substrate. The second doped structure is a tunnel passivation contact structure. The tunnel passivation contact structure contains impurities of a conductive type opposite to that of the diffusion region. Through optimization of the first doped structure and the second doped structure, in the present disclosure, the first doped structure may be formed through diffusion, then diffusion junctions in part of regions may be removed, and then the tunnel passivation contact structure may be deposited, which is highly compatible with process flow of a TOPCon cell and suitable for industrial promotion.

## Description

### FIELD

The present disclosure relates to the field of photovoltaics, and in particular, to a solar cell.

### BACKGROUND

A back contact (BC) solar cell has a positive electrode and a negative electrode that are both located at a back surface of the solar cell, which can shorten a current transmission path and lower resistance. Moreover, the BC solar cell has no gridline on a front surface of the solar cell, which improves light absorption efficiency, and improves cell performance.

However, despite significant advantages of the BC solar cell over other battery technologies, a structural design of the solar cell affects its mass production progress.

In view of this, it is necessary to provide an improved solar cell to solve the above technical problems.

### SUMMARY

The present disclosure provides a solar cell with an improved structural design on a back surface of the solar cell, which is beneficial to industrialization.

To achieve one of the above objectives of the present disclosure, the present disclosure adopts the following technical solutions.

A solar cell includes: a silicon substrate having a front surface and a back surface that face away from each other, a first doped structure, a second doped structure, a first electrode and a second electrode. The back surface of the silicon substrate has a first region, a second region, and an isolation region located between the first region and the second region. The back surface of the silicon substrate in the second region is recessed towards the front surface of the silicon substrate with respect to the back surface of the silicon substrate in the first region. The first doped structure is disposed in the first region, and the first doped structure is a diffusion region formed by diffusing a dopant from the back surface into the silicon substrate. The second doped structure is disposed in the second region. The second doped structure is a tunnel passivation contact structure. The tunnel passivation contact structure contains impurities of a conductive type opposite to that of the diffusion region. The first electrode is disposed at a back surface of the first doped structure. The second electrode is disposed at a back surface of the second doped structure.

In this embodiment, the front surface of the silicon substrate is a primary light-receiving surface of the silicon substrate, and the back surface of the silicon substrate is a secondary light-receiving surface of the silicon substrate. Each of the first doped structure and the second doped structure has a front surface and a back surface that face away from each other. The front surface of the first doped structure is a surface of the first doped structure facing towards the front surface of the silicon substrate. The back surface of the first doped structure is the surface of the first doped structure facing away from the front surface of the silicon substrate. The front surface of the second doped structure is a surface of the second doped structure facing towards the silicon substrate. The back surface of the second doped structure is the surface of the second doped structure facing away from the silicon substrate.

In this embodiment, the first electrode being disposed at the back surface of the first doped structure means that the first electrode is positioned on the side of the first doped structure that corresponds to its back surface. Similarly, the second electrode being disposed at the back surface of the second doped structure means that the second electrode is positioned on the side of the second doped structure that corresponds to its back surface. In practical applications, both the first and second electrodes extend in a direction from the back surface towards inside of the silicon. A portion of the first electrode extends into the first doped structure for electrical contact, and a portion of the second electrode extends into the second doped structure for electrical connection.

In an embodiment, the back surface of the silicon substrate in the isolation region is recessed towards the front surface of the silicon substrate with respect to the back surface of the silicon substrate in the first region. A recess depth of the back surface of the silicon substrate in the second region recessed towards the front surface of the silicon substrate and/or a recess depth of the back surface of the silicon substrate in the isolation region recessed towards the front surface of the silicon substrate is greater than or equal to a diffusion depth of the diffusion region.

In an embodiment, a width of the isolation region ranges from 10 µm to 150 µm.

In an embodiment, a distance from the back surface of the silicon substrate in the isolation region to the back surface of the first doped structure ranges from 1 µm to 20 µm.

In an embodiment, a distance from the back surface of the second doped structure to the front surface of the silicon substrate is smaller than or equal to a distance from the back surface of the first doped structure to the front surface of the silicon substrate.

In an embodiment, a size of the second doped structure in a thickness direction of the silicon substrate is smaller than or equal to a recess depth of the back surface of the silicon substrate in the isolation region recessed towards the front surface of the silicon substrate.

In an embodiment, a distance, in the thickness direction of the silicon substrate, from the back surface of the first doped structure to the back surface of the second doped structure ranges from 1 µm to 10 µm.

In an embodiment, the first doped structure includes a grid line region and a non-grid line region. A doping concentration of the grid line region is greater than a doping concentration of the non-grid line region. The first electrode is in contact with the grid line region.

In an embodiment, sheet resistance of the grid line region ranges from 80 ohm/sq to 130 ohm/sq, and sheet resistance of the non-grid line region ranges from 200 ohm/sq to 400 ohm/sq.

In an embodiment, the tunnel passivation contact structure includes: at least one tunneling layer; and at least one doped polysilicon layer each disposed on a side of one of the at least one tunneling layer facing away from the silicon substrate. The second electrode is in contact with the doped polysilicon layer.

In this embodiment, the tunnel passivation contact structure includes the at least one tunneling layer and the at least one doped polysilicon layer. The tunnel passivation contact structure containing impurities of a conductive type opposite to that of the diffusion region means that the diffusion region contains impurities of a conductive type opposite to that of each of the at least one doped polysilicon layer in the tunnel passivation contact structure.

In an embodiment, the at least one tunneling layer comprises n tunneling layers and the at least one doped polysilicon layer comprises n doped polysilicon layers, where n≥2. Each of the n doped polysilicon layers is disposed on a side of a corresponding one of the n tunneling layers facing away from the silicon substrate. The second electrode is in contact with at least one of the 2-nd to n-th doped polysilicon layers, in a direction from the front surface to the back surface of the silicon substrate, of the n doped polysilicon layers.

In an embodiment, the first doped structure is a P-type diffusion region, and each of the at least one doped polysilicon layer is an N-type doped polysilicon layer; or the first doped structure is an N-type diffusion region, and each of the at least one doped polysilicon layer is a P-type doped polysilicon layer.

In an embodiment, in a direction from the front surface to the back surface of the silicon substrate, a height of the first doped structure is greater than a height of the second doped structure.

In an embodiment, a height difference between the back surface of the first doped structure and the back surface of the second doped structure ranges from 0.5 to 1.5 times a diffusion depth of the diffusion region.

In an embodiment, a size of the back surface of the silicon substrate in the isolation region ranges from 15 µm to 30 µm, or a roughness of the back surface of the silicon substrate in the isolation region is smaller than or equal to 10 nm.

In an embodiment, the back surface of the solar cell has a textured structure in all regions except for the isolation region.

In an embodiment, the solar cell further includes a passivation film layer. The passivation film layer in the isolation region includes a first charge film layer in contact with the silicon substrate and a second charge film layer formed on a side of the first charge film layer facing away from the silicon substrate. The first charge film layer and the silicon substrate are of the same charge type, and the first charge film layer and the second charge film layer are of opposite charge types.

In an embodiment, a thickness of the first charge film layer is smaller than a thickness of the second charge film layer.

In an embodiment, the silicon substrate is of N-type silicon, the first charge film layer is a negative charge film layer, and the second charge film layer is a positive charge film layer; or the silicon substrate is of P-type silicon, the first charge film layer is a positive charge film layer, and the second charge film layer is a negative charge film layer.

In an embodiment, the negative charge film layer includes a silicon oxide film layer in contact with the silicon substrate and an aluminum oxide film layer formed on a side of the silicon oxide film layer facing away from the silicon substrate.

In an embodiment, a thickness of the silicon oxide film layer ranges from 0.5 nm to 2 nm, and a thickness of the aluminum oxide film layer ranges from 1 nm to 20 nm.

In an embodiment, the positive charge film layer is selected from at least one of a SiNx film layer or a SiOxNy film layer.

In an embodiment, a thickness of the positive charge film layer ranges from 10 nm to 100 nm.

Beneficial effects of the present disclosure are as follows. In the solar cell of the present disclosure, by disposing each of the first electrode and the second electrode on the back surface of the silicon substrate, there is no metal electrode obscuration on the front surface of the silicon substrate, thereby maximizing the light-receiving area of the solar cell and improving the light conversion efficiency of the solar cell, and thus improving an overall efficiency of the solar cell. Moreover, the solar cell includes the front surface and the back surface that face away from each other. The back surface of the silicon substrate includes the first region, the second region, and the isolation region located between the first region and the second region. The back surface of the silicon substrate in the second region is recessed towards the front surface of the silicon substrate with respect to the back surface of the silicon substrate in the first region. The first doped structure is disposed in the first region, and is the diffusion region formed by diffusing the dopant from the back surface of the silicon substrate into the silicon substrate. The second doped structure is disposed in the second region, and is a tunnel passivation contact structure disposed on the back surface of the silicon substrate in the second region. This design allows for the initial formation of the first doped structure by diffusion, followed by the removal of the diffusion junction in certain areas, and then the deposition of the tunnel passivation contact structure. It is highly compatible with the manufacturing process of TOPCon solar cells and is well-suited for industrial-scale production.

### BRIEF DESCRIPTION OF THE DRAWINGS

FIG. 1 is a schematic structural view of a solar cell according to an embodiment of the present disclosure;
FIG. 2 is a schematic structural view of a solar cell according to an embodiment of the present disclosure;
FIG. 3 is a schematic structural view of a solar cell according to an embodiment of the present disclosure;
FIG. 4 is a schematic structural view of a solar cell according to an embodiment of the present disclosure;
FIG. 5 is a schematic structural view of a solar cell according to an embodiment of the present disclosure;
FIG. 6 is a schematic structural view of a solar cell according to an embodiment of the present disclosure;
FIG. 7 is a schematic structural view of a solar cell according to an embodiment of the present disclosure;
FIG. 8 is a schematic structural view of a solar cell according to an embodiment of the present disclosure;
FIG. 9 is a schematic structural view of a solar cell according to an embodiment of the present disclosure;
FIG. 10 is a schematic structural view of a solar cell according to an embodiment of the present disclosure;
FIG. 11 is a schematic structural view of a solar cell according to an embodiment of the present disclosure;
FIG. 12 is a schematic structural view of a solar cell according to an embodiment of the present disclosure;
FIG. 13 is a schematic structural view of a solar cell according to an embodiment of the present disclosure; and
FIG. 14 is a schematic structural view of a solar cell according to an embodiment of the present disclosure.

### DETAILED DESCRIPTION

The present disclosure will be described in detail below in combination with specific embodiments shown in the accompanying drawings, but these embodiments do not limit the present disclosure. Structural, methodological, or functional transformations made by those skilled in the art according to these embodiments shall fall within the scope of protection of the present disclosure.

In the accompanying drawings of the present disclosure, some dimensions of structures or parts are exaggerated relative to those of other structures or parts for ease of illustration, which is only intended to illustrate the basic structure of the subject matter of the present disclosure.

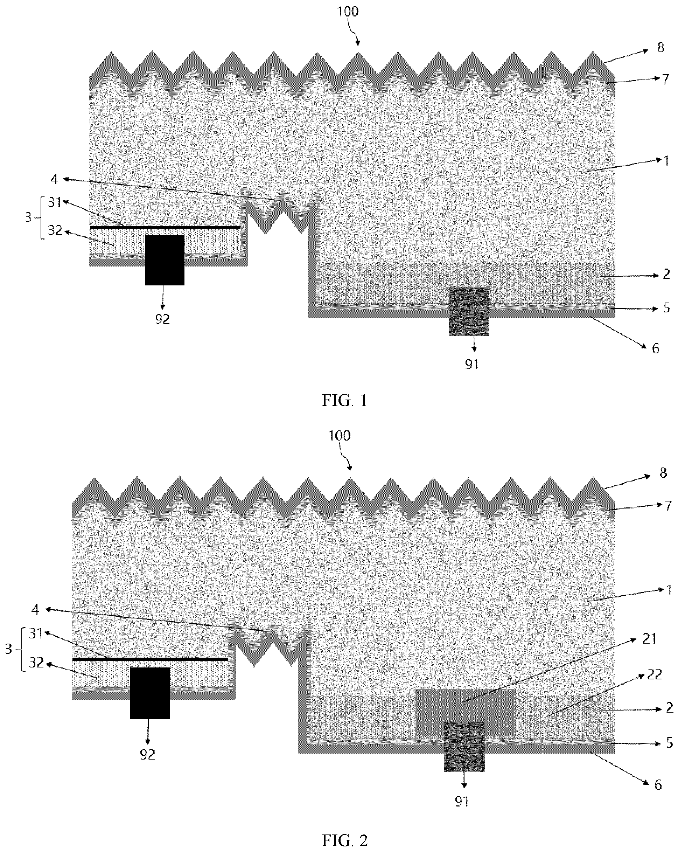

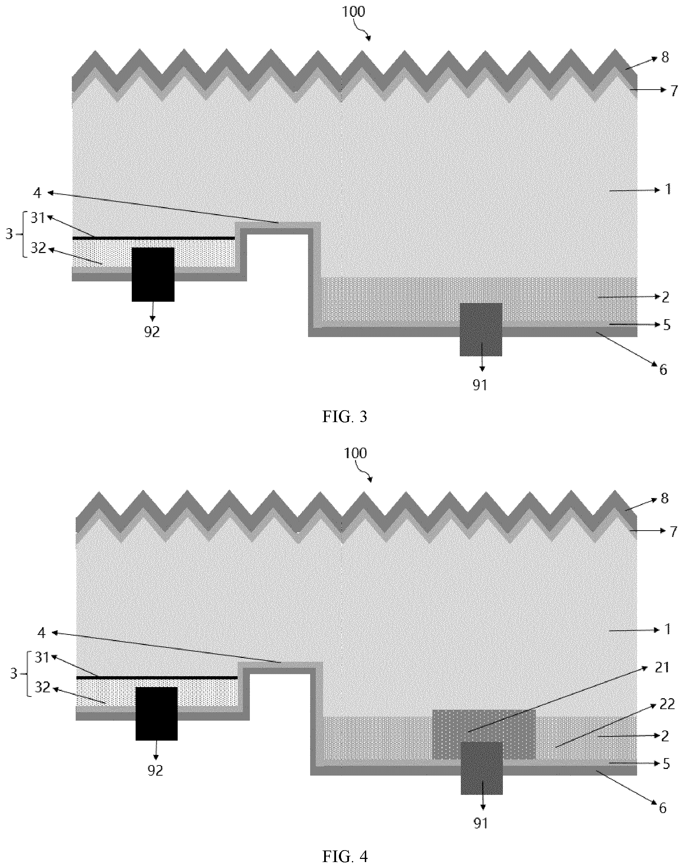

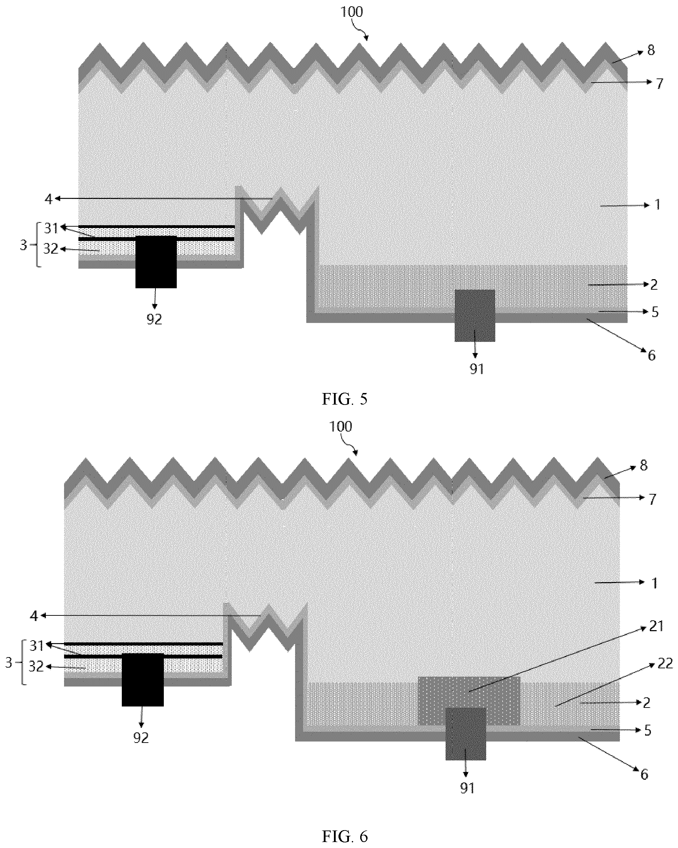

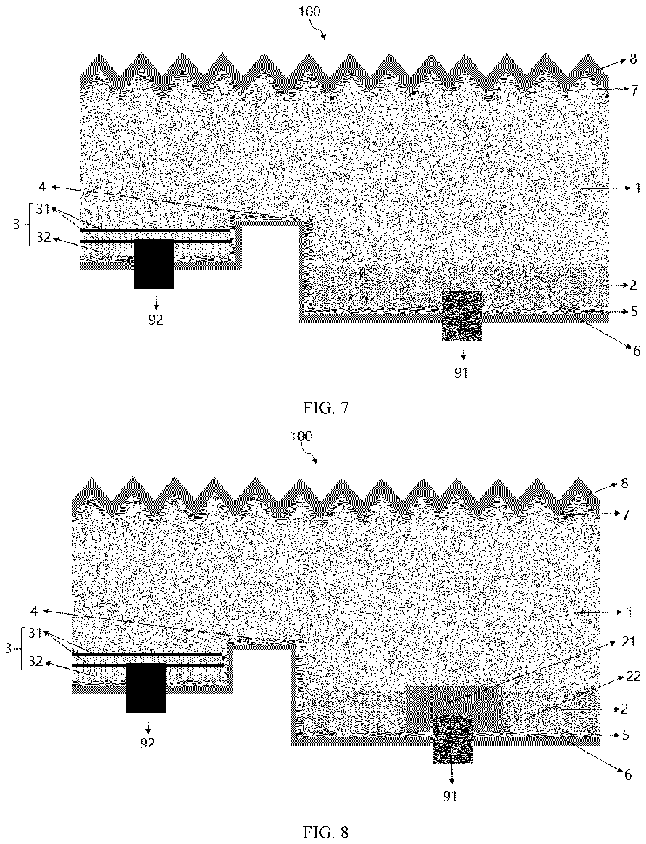

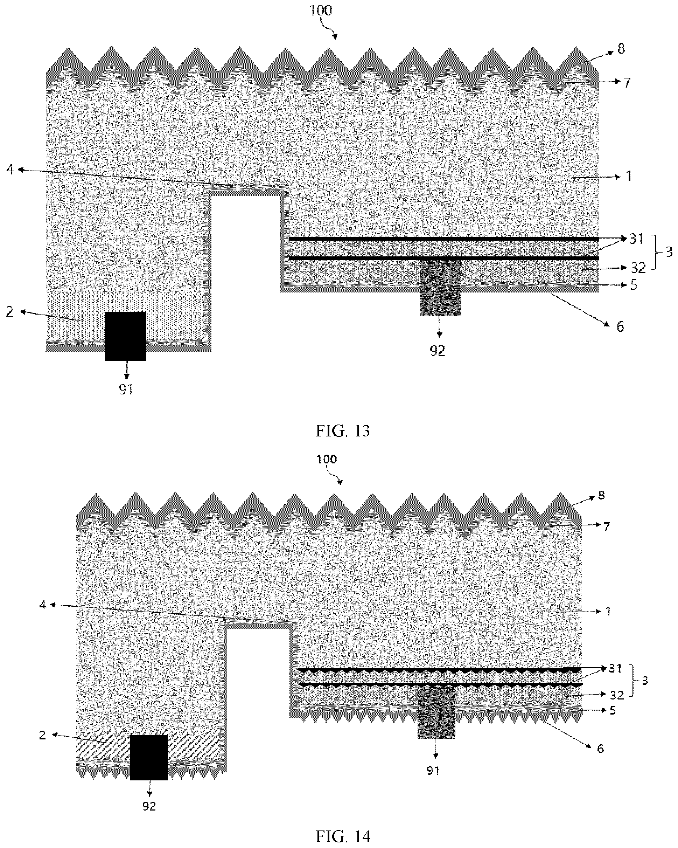

FIG. 1 to FIG. 14 show a solar cell 100 according to a preferred embodiment of the present disclosure. The solar cell 100 includes a silicon substrate 1, a first doped structure 2 located at a back surface of the silicon substrate 1, a second doped structure 3 located at the back surface of the silicon substrate 1, an isolation region 4 located between the first doped structure 2 and the second doped structure 3, a first electrode 91 located at a back surface of the first doped structure 2, and a second electrode 92 located at a back surface of the second doped structure 3.

The silicon substrate 1 includes a front surface and a back surface that face away from each other. The front surface of the silicon substrate 1 is a primary light-receiving surface of the silicon substrate 1, and the back surface of the silicon substrate 1 is a secondary light-receiving surface of the silicon substrate. An N-type silicon wafer with electrical resistivity ranging from 0.3Ω·cm to 7Ω·cm, preferably 2Ω·cm to 3.5Ω·cm, is selected as the silicon substrate 1. In an embodiment, the front surface of the silicon substrate 1 has a textured structure, with a good light limiting effect, which can further improve a light utilization rate.

Each of the first doped structure 2 and the second doped structure 3 includes a front surface and a back surface that face away from each other. The front surface of the first doped structure 2 is a surface of the first doped structure 2 facing towards the front surface of the silicon substrate 1. The back surface of the first doped structure 2 is a surface of the first doped structure 2 facing away from the front surface of the silicon substrate 1. The front surface of the second doped structure 3 is a surface of the second doped structure 3 facing towards the silicon substrate 1. The back surface of the second doped structure 3 is a surface of the second doped structure 3 facing away from the silicon substrate 1.

In this embodiment, the first electrode 91 being disposed at the back surface of the first doped structure 2 means that the first electrode 91 is positioned on the side of the first doped structure 2 that corresponds to its back surface. Similarly, the second electrode 92 being disposed at the back surface of the second doped structure 3 means that the second electrode 92 is positioned on the side of the second doped structure 3 that corresponds to its back surface. In practical applications, both the first and second electrodes 91 and 92 extend in a direction from the back surface towards inside of the silicon. A portion of the first electrode 91 extends into the first doped structure for electrical contact, and a portion of the second electrode 92 extends into the second doped structure for electrical connection.

The first doped structure 2 contains impurities of a conductive type opposite to that of the second doped structure 3. One of the first doped structure 2 and the second doped structure 3 is a P-type doped structure, and the other one of the first doped structure 2 and the second doped structure 3 is an N-type doped structure. The first doped structure 2 and the second doped structure 3 are alternately arranged, and are separated by the isolation region 4. By disposing both the first doped structure 2 and the second doped structure 3 on a back surface of the cell (i.e., a secondary light-receiving surface of the cell), it is possible to reduce a current transmission path between the P-type doped structure and the N-type doped structure and lower resistance. Moreover, by disposing both the first electrode 91 and the second electrode 92 on the back surface of the solar cell, the front surface of the solar cell (i.e., a primary light-receiving surface of the solar cell) is not obstructed by metal electrodes. This maximizes the large light-receiving area and improves cell efficiency.

The first doped structure 2 is a diffusion region formed by diffusing a dopant (i.e., towards the front surface of the silicon substrate 1) from the back surface of the silicon substrate 1 into the silicon substrate 1. A diffusion depth of the dopant in a thickness direction of the silicon substrate 1 is called a junction depth.

In a first embodiment, as shown in FIG. 1 to FIG. 8, the first doped structure 2 is a P-type diffusion region, and the second doped structure 3 is an N-type tunnel passivation contact structure.

The first doped structure 2 is the P-type doped structure. Specifically, it is a P-type diffusion region formed by diffusing the P-type dopant from the back surface of the silicon substrate 1 into the silicon substrate 1. In this case, a PN junction is located inside the silicon substrate 1, which is beneficial to separation and collection of carriers, thereby improving the cell efficiency. The P-type dopant includes, but is not limited, to boron, aluminum, gallium, and the like.

As shown in FIG. 1, FIG. 3, FIG. 5, and FIG. 7, the entire diffusion region has uniform doping concentration.

As shown in FIG. 2, FIG. 4, FIG. 6, and FIG. 8, the first doped structure 2 includes a grid line region 21 and a non-grid line region 22. A doping concentration of the grid line region 21 is greater than a doping concentration of the non-grid line region 22.

The grid line region 21 has a high doping concentration, which forms an ohmic contact with the first electrode 91. This reduces series resistance of the solar cell and improves a fill factor FF of the solar cell. The non-grid line region 22 has a low doping concentration, which can reduce a chance of carrier surface recombination and reduce a reverse saturation current of the solar cell, thereby improving an open-circuit voltage Voc and a short-circuit current Isc of the solar cell. In addition, a P++/P+ or N++/N+ high-low junction may be formed laterally in the grid line region 21 and the non-grid line region 22, which is beneficial to an improvement in the collection of carriers and a further increase in the short-circuit current Isc.

In an embodiment, the grid line region 21 has a doping concentration ranging from 5E18 cm⁻³ to 1E20 cm⁻³ and sheet resistance ranging from 80 ohm/sq to 130 ohm/sq. The non-grid line region 22 has sheet resistance ranging from 200 ohm/sq to 400 ohm/sq.

The second doped structure 3 is located in a region recessed towards the front surface of the silicon substrate 1 from the back surface of the silicon substrate 1. The second doped structure 3 is a tunnel passivation contact structure. The tunnel passivation contact structure includes at least one tunneling layer 31 and a doped polysilicon layer 32 located on a side of each tunneling layer 31 facing away from the silicon substrate 1. The second electrode 92 is in contact with the doped polysilicon layer 32.

The tunneling layer 31 is selected from a silicon oxide layer (SiOx) or a silicon carbide layer (SiC) and has a thickness ranging from 1 nm to 3 nm, preferably from 1 nm to 2.5 nm, and more preferably from 1 nm to 2 nm or from 1.5 nm to 2.5 nm. The thickness of the tunneling layer 31 is optimized based on denseness of the tunneling layer 31. When the tunneling layer 31 is made of SiOx, the thickness of the tunneling layer 31 ranges from 1.4 nm to 2.3 nm. When the tunneling layer 31 is made of SiC, the layer is denser and thus has a thickness ranging from 1 nm to 1.8 nm.

The doped polysilicon layer 32 is an N-doped polysilicon layer which will be illustrated with phosphorus doping as example. The doping concentration of phosphorus in the doped polysilicon layer ranges from 1E19 cm⁻³ to 1E21 cm⁻³, preferably from 1E20 cm⁻³ to 9E20 cm⁻³. A thickness of the doped polysilicon layer ranges from 80 nm to 120 nm, which can be set to 90 nm, 85 nm, 100 nm, 105 nm, 110 nm, or 115 nm.

In an embodiment, the passivation contact structure includes one tunneling layer 31 and one doped polysilicon layer 32. The second electrode 92 is in contact with the doped polysilicon layer 32, preventing the second electrode 92 from being in direct contact with the silicon substrate 1 and improving the cell efficiency.

In another embodiment, the tunnel passivation contact structure includes n tunneling layers 31 and n doped polysilicon layers 32. Each of the n doped polysilicon layers is disposed on a side of a corresponding one of the n tunneling layers 31 facing away from the silicon substrate 1, where n≥2. The plurality of tunneling layers 31 may achieve an effect of obstructing diffusion of metallic silver into the silicon substrate, preventing the metallic silver from being in contact with the silicon substrate to form a silicon-silver alloy.

In a direction from the front surface to the back surface of the silicon substrate 1, the second electrode 92 is in contact with at least one of the 2-nd to n-th doped polysilicon layers 32. That is, the second electrode 92 is in contact with a part or all of other doped polysilicon layers 32 except for the one closest to the silicon substrate 1. The second electrode 92 will not reach the innermost doped polysilicon layer, preventing silver from being in direct contact with the silicon substrate.

In an embodiment, the passivation contact structure includes two doped polysilicon layers, and the second electrode 92 is only in contact with a doped polysilicon layer 32 farthest from the silicon substrate 1.

In another embodiment, the passivation contact structure includes three doped polysilicon layers 32. The second electrode 92 is only in contact with the outermost doped polysilicon layer 32 or with the first and second doped polysilicon layers 32 counted from the outside to the inside of the passivation contact structure. It should be understood that in the embodiments of the present disclosure, the second doped structure 3 is a tunnel passivation contact structure including a plurality of film layers. The first doped structure 2 containing impurities of a conductive type opposite to that of the second doped structure 3 mentioned above means that the first doped structure 2 contains impurities of a conductive type opposite to that of a doped polysilicon layer 32 in the tunnel passivation contact structure (i.e., the second doped structure 3). For example, in this embodiment, the first doped structure 1 is a P-type diffusion region, and the doped polysilicon layer is an N-type doped polysilicon layer. For another example, in another embodiment (such as a second embodiment below), the first doped structure 1 is an N-type diffusion region, and the doped polysilicon layer is a P-type doped polysilicon layer.

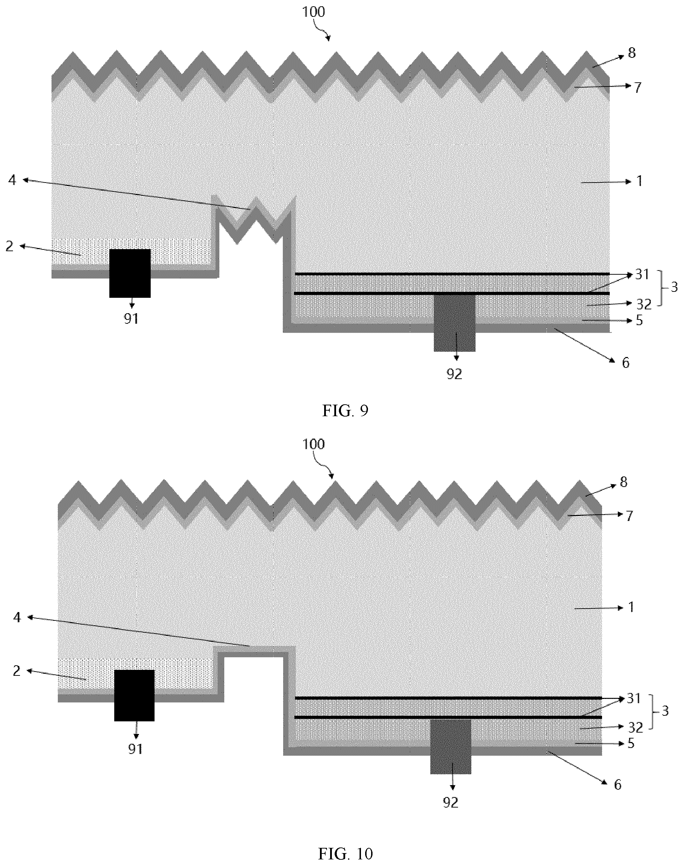

In the second embodiment, as shown in FIG. 9 to FIG. 14, the first doped structure 2 is an N-type diffusion region. The main difference between the N-type diffusion region and a P-type diffusion region is that the N-type diffusion region is formed by diffusing an N-type dopant from the back surface of the silicon substrate 1 into the silicon substrate 1. The N-type dopant includes but is not limited to phosphorus, arsenic, antimony, and the like.

The second doped structure 3 is the P-type doped structure. The only difference between the P-type doped structure and the N-type doped structure is that the doped polysilicon layer 32 is a P-type doped polysilicon layer, and the dopant is a P-type dopant.

In addition, a width of the P-type doped structure is greater than a width of the N-type doped structure, and an area of a region where a P-N junction is located is greater than an area of a N-N+ region, which is beneficial to generation, separation, and collection of photogenerated carriers and can improve the cell efficiency.

In an embodiment, the width of the P-type doped structure 2 ranges from 1.5 to 2 times the width of the N-type doped structure.

In addition, as shown in FIG. 1 to FIG. 8 and FIG. 12 to FIG. 14, in a direction from the front surface to the back surface of the silicon substrate 1, a height of the first doped structure 2 is greater than a height of the second doped structure 3. By having the height of the first doped structure 2 greater than the height of the second doped structure 3, on the one hand, a surface area of the entire back surface of the solar cell is increased, expanding the light-receiving area. On the other hand, each of the back surface and side surface of the first doped structure 2 is exposed outwards, increasing a light-absorbing area of the first doped structure 2. This enables the generation and successful collection of more carriers, thereby improving the cell efficiency.

Of course, as shown in FIG. 9 to FIG. 11, in the direction from the front surface to the back surface of the silicon substrate 1, the height of the second doped structure 3 is greater than the height of the first doped structure 2, which can also increase the surface area of the back surface of the solar cell, improve a light-receiving area of a back surface in a bifacial module, and improve the cell efficiency.

Preferably, as shown in FIG. 1 to FIG. 11, the height of the P-type doped structure is greater than the height of the N-type doped structure. The greater a height difference between the P-type doped structure and the N-type doped structure, the larger the area of the P-type diffusion region that is exposed outwards, which is more beneficial to light absorption, results in higher cell efficiency.

Referring to FIG. 1 to FIG. 8, the first doped structure 2 is the P-type diffusion region, and the second doped structure 3 is an N-type passivation contact structure. A height difference between the back surface of the N-type doped structure (i.e., the second doped structure 3) and the back surface of the P-type doped structure (i.e., the first doped structure 2) ranges from 0.5 to 1.5 times a diffusion depth of the P-type diffusion region.

Referring to FIG. 9 to FIG. 11, the first doped structure 2 is the N-type diffusion region, and the second doped structure 3 is a P-type passivation contact structure. A height difference between a back surface of the N-type doped structure (i.e., the first doped structure 2) and a back surface of the P-type doped structure (i.e., the second doped structure 3) ranges from 0.5 to 1.5 times a thickness of the P-type passivation contact structure.

The isolation region 4 is between the first doped structure 2 and the second doped structure 3 such that the first doped structure 2 and the second doped structure 3 are separated by the isolation region 4 to avoid the occurrence of a leakage problem caused by contact between the first doped structure 2 and the second doped structure 3. A width of the isolation region 4 refers to a gap between the first doped structure 2 and the second doped structure 3. For example, in FIGS. 1 and 9, the width of the isolation region 4 is denoted by D.

In an embodiment, a width of the isolation region 4 ranges from 10 µm to 150 µm. On the premise of isolating leakage, the narrower the width of the isolation region 4, the smaller carrier recombination in this region, and the higher the cell efficiency. Preferably, the width of the isolation region 4 ranges from 50 µm to 100 µm.

In the present disclosure, the isolation region 4 is recessed towards the front surface of the silicon substrate 1 from the back surface of the silicon substrate 1. Moreover, a recess depth at a position where the second doped structure 2 is located and/or a recess depth of the isolation region 4 is greater than or equal to the diffusion depth of the diffusion region. Such a design ensures that the first doped structure 2 and the second doped structure 3 are completely separated by the isolation region 4. The recess depth at the position where the second doped structure 2 is located refers to a depth by which the back surface of the silicon substrate is recessed towards the front surface of the silicon substrate at that position. Similarly, a recess depth of the isolation region 4 refers to a depth by which the back surface of the silicon substrate in the isolation region 4 is recessed towards the front surface of the silicon substrate, i.e., a recess depth of the back surface of the silicon substrate in the isolation region 4 recessed towards the front surface of the silicon substrate.

In an embodiment, the recess depth of the position where the second doped structure 2 is located is smaller than the recess depth of the isolation region 4, such that the diffusion region and the passivation contact structure are completely separated both in an extending direction and a thickness direction of the silicon substrate 1, resulting in a good isolation effect.

A distance from a back surface of the isolation region 4 (i.e., a surface of the isolation region 4 facing towards the front surface of the silicon substrate 1) to the back surface of the first doped structure 2 is called a depth of the isolation region 4. The depth of the isolation region 4 ranges from 1 µm to 20 µm, preferably from 5 µm to 10 µm. Alternatively, the depth of the isolation region 4 preferably exceeds the diffusion depth of the diffusion region to ensure that the P-type doped structure 2 and the N-type doped structure 3 are completely separated by the isolation region 4. In an embodiment, the depth of the isolation region 4 ranges from 1 to 1.5 times the diffusion depth of the P-type diffusion region.

In an embodiment, a distance from the back surface of the second doped structure 3 to the front surface of the silicon substrate 1 is smaller than or equal to a distance from the back surface of the first doped structure 2 to the front surface of the silicon substrate 1. Alternatively, a size of the second doped structure 3 in the thickness direction of the silicon substrate 1 is smaller than or equal to the recess depth of the isolation region 4.

With such a design, a height difference is formed between the first doped structure 2 and the second doped structure 3 on the back surface of the silicon substrate 1, increasing the surface area of the back surface, i.e., increasing the light-absorbing area, which can improve the cell efficiency.

In an embodiment, a distance, in the thickness direction of the silicon substrate 1, from the back surface of the first doped structure 2 to the back surface of the second doped structure 3 ranges from 1 µm to 10 µm. This not only increases the surface area of the back surface and but also creates a stepped shape, allowing light to undergo a plurality of reflections on the back surface, which is more facilitate to light absorption. Preferably, the height difference between the back surface of the first doped structure 2 and the back surface of the second doped structure 3 ranges from 4 µm to 10 µm.

In addition, a surface of the isolation region 4 facing towards the silicon substrate 1 is a textured structure, which can improve light absorption of this surface and is beneficial to the improvement of the cell efficiency. Moreover, a preparation process of the entire cell is simple. Alternatively, a back surface of the isolation region 4 facing towards the front surface of the silicon substrate 1 is a plane, which significantly reduces a dangling bond of the surface compared to the textured structure, lowering a chance of carrier recombination at this location, and thus can improve the cell efficiency. Moreover, the planar isolation region 4 facilitates the formation of a continuous passivation film layer in subsequent processes, further achieving a good passivation effect. Under the premise of other unchanged structures, this can increase the cell efficiency by 0.1% to 0.2%.

It should be noted that "the surface is planar" means the surface of the isolation region 4 has a terrace base size ranging from 15 µm to 30 µm, or surface roughness of the isolation region 4 is comparable to roughness of a planar silicon wafer, generally not exceeding 10 nm.

Based on the planar isolation region 4, a continuous passivation film may be formed on a surface of the planar isolation region 4, thereby improving a passivation effect of the isolation region 4. Under the premise of other unchanged structures, it is possible to increase the cell efficiency by 0.1% to 0.2%.

On the basis of any of the above structural designs, the textured structure is formed on the back surface of the solar cell excluding the isolation region 4, which can improve the light absorption and improve the cell efficiency. How to maintain the surface of the isolation region 4 as planar while the textured structure is formed on other regions on the back surface of the silicon substrate 1 and even the front surface of the silicon substrate 1 is a technical challenge, which will be described in the preparation method below.

In addition, a passivation layer 5 and an anti-reflection layer 6 are formed on the back surface of the solar cell 100. For ease of understanding, the passivation layer 5 and the anti-reflection layer 6 are also referred to as a back surface passivation layer 5 and a back surface anti-reflection layer 6 in the following text. The first electrode 91 penetrates the back surface anti-reflection layer 6 and the back surface passivation layer 5 to make contact with the grid line region 21. The second electrode 92 penetrates the back surface anti-reflection layer 6 and the back surface passivation layer 5 to make contact with the doped polysilicon layer 32.

In an embodiment, the back surface passivation layer 5 is preferably an aluminum oxide layer, providing an excellent field passivation effect for the first doped structure 2 and an excellent interface passivation effect for the second doped structure 3. In the present disclosure, a thickness of the back surface passivation layer 5 preferably ranges from 3 nm to 6 nm.

In another embodiment, the back surface passivation layer 5, particularly a back surface passivation layer 5 on the isolation region 4, includes a first charge film layer in contact with the silicon substrate 1 and a second charge film layer formed on a side of the first charge film layer facing away from the silicon substrate 1. The first charge film layer and the silicon substrate 1 are of the same charge type, and the first charge film layer and the second charge film layer are of opposite charge types.

The surface of the silicon substrate 1 has a dangling bond. Interface passivation is performed with the first charge film layer, which has the same charge as the silicon substrate, and field passivation is performed with the second charge film layer, which has the charge opposite to that of the first charge film layer. In this way, a passivation effect of the entire passivation film layer can be improved.

In the present disclosure, the silicon substrate is an N-type silicon wafer, the first charge film layer is a negative charge film layer, and the second charge film layer is a positive charge film layer. It can be understood by those skilled in the art that when the silicon substrate is a P-type silicon wafer, the first charge film layer is the positive charge film layer, and the second charge film layer is the negative charge film layer.

In an embodiment, the negative charge film layer includes a silicon oxide film layer and an aluminum oxide film layer formed on a side of the silicon oxide film layer facing away from the silicon substrate. The silicon oxide film layer has higher denseness than the aluminum oxide film layer. Therefore, by forming the silicon oxide film layer on the surface of the isolation region 4, followed by the formation of the aluminum oxide film layer can achieve the best passivation effect.

A thickness of the silicon oxide film layer ranges from 0.5 nm to 2 nm (for example, is 1 nm), and a thickness of the aluminum oxide film layer ranges from 1 nm to 20 nm.

In an embodiment, the positive charge film layer is selected from at least one of a SiNx film layer or a SiOxNy film layer.

A thickness of the positive charge film layer ranges from 10 nm to 100 nm.

In addition, a thickness of the first charge film layer is smaller than a thickness of the second charge film layer. The first charge film layer only needs to achieve the interface passivation, and an excessively thick first charge film layer will affect formation of field passivation by the second charge film layer. Moreover, the second charge film layer needs to overcome an impact of an intermediate first charge film layer to form a field passivation effect, so a relatively larger thickness is required for the second charge film layer.

In an embodiment, the thickness of the first charge film layer ranges from 0.5 nm to 25 nm, preferably from 2 nm to 10 nm. The thickness of the second charge film layer ranges from 10 nm to 100 nm, preferably from 20 nm to 50 nm.

On the basis of the surface of the isolation region 4 being planar, in cooperation with the passivation film layer, the passivation effect in the isolation region 4 may be optimized to the best state.

The back surface anti-reflection layer 6 is selected from a laminated film made of one or more of silicon nitride, silicon oxynitride, or silicon oxide, and has a thickness ranging from 60 nm to 130 nm, which reduces reflectivity and improves the light utilization rate.

In an embodiment, the solar cell 100 further includes a front surface passivation layer 7 and a front surface anti-reflection layer 8 that are sequentially formed on the front surface of the silicon substrate 1, to passivate a surface defect of the front surface of the silicon substrate 1. In the present disclosure, the front surface passivation layer 7 and the back surface passivation layer 5 are made of the same material and have the same thickness, and the front surface passivation layer 7 and the back surface passivation layer 5 may be deposited in one process. The front surface anti-reflection layer 8 and the back surface anti-reflection layer 6 are made of the same material and have the thickness, and the front surface anti-reflection layer 8 and the back surface anti-reflection layer 6 may also be deposited in one process.

In the solar cell 100 of the present disclosure, the first doped structure 2 is the diffusion region formed by diffusing the dopant from the back surface into the silicon substrate 1. The second doped structure 3 is located in the region recessed towards the front surface of the silicon substrate 1 from the back surface of the silicon substrate 1 and is the tunnel passivation contact structure. This structural design allows for the initial formation of the first doped structure 2 at the back surface of the silicon substrate 1 through diffusion. Followed by the removal of diffusion junctions in certain regions, and the tunnel passivation contact structure is then deposited, which is highly compatible with the manufacturing process of TOPCon solar cells and is well-suited for industrial-scale production.

Hereinafter, referring to FIG. 1 to FIG. 8, a first method for fabricating a solar cell is provided, with the first doped structure 2 being a boron-doped P-type diffusion region, and the second doped structure being a phosphorus-doped N-type tunnel passivation contact structure as examples.

At S1, a diffusion region (boron junction) and a BSG layer are formed on the back surface of the silicon substrate 1 using a boron diffusion process.

At S11, a boron source is formed on the entire back surface of the silicon substrate 1. The silicon substrate 1 is fixed in a quartz boat and fed into a tube furnace, and the boron source and oxygen are introduced to deposit a layer of boron source (also referred to as "source feeding") on the back surface of the silicon substrate 1. The boron source is boron trichloride (BCl₃) with a flow rate ranging from 90 sccm to 150 sccm, an oxygen flow rate for reacting with BCl₃ ranges from100 sccm to 500 sccm, and an oxygen flow rate for generating an oxide layer ranges from 1slm to 10 slm. Alternatively, the boron source is boron tribromide (BBr₃) with a flow rate ranging from 90 sccm to 150 sccm, an oxygen flow rate for reacting with BBr3 ranges from 100 sccm to 500 sccm, and the oxygen flow rate for generating the oxide layer ranges from 1 slm to 10 slm.

At S12, laser scanning is performed on the grid line region of the first doped structure 2 to form a heavily doped grid line region 21. Laser parameters include: laser gas power of 120W, using 63% power for wafer processing; and a laser frequency of 100kHz and a scanning speed of 25m/s.

At S13, diffusion is performed in the non-grid line region.

In an embodiment, the heavily doped silicon substrate 1 is placed into a tube furnace, and the oxygen is introduced into the tube furnace at a temperature ranging from 950°C to 1000°C and an oxygen flow rate ranging from 10 slm to 15 slm. At a high temperature, boron in the non-grid line region is diffused inwards to form the non-grid line region 22, while the BSG layer is formed on the entire surface.

In an embodiment, the sheet resistance after the boron source is deposited ranges from 120 ohm/sq to 170 ohm/sq. After the laser scanning, the grid line region 21 has a doping concentration ranging from 5E18 cm⁻³ to 1E20 cm⁻³ and sheet resistance ranging from 80 ohm/sq to 130 ohm/sq. After high-temperature oxidation, the sheet resistance of the non-grid line region 22 ranges from 200 ohm/sq to 400 ohm/sq.

In the present disclosure, a diffusion depth of boron (a depth of boron junction) ranges from 0.5 µm to 1.0 µm. By controlling the diffusion depth of boron, a passivation effect and metal contact of a P region are optimized. The diffusion depth of boron is designed to range from 0.5 µm to 1.0 µm, which can ensure a dark saturation current density J0 of the diffusion region ranges from 2 fA/cm² to 4 fA/cm², achieving a balanced passivation effect with the second doped structure 3 having a dark saturation current density J0 ranging from 1fA/cm² to 3fA/cm². When the diffusion depth of boron exceeds 1 µm, an increase in Auger recombination and a decrease in a bulk lifetime of the silicon wafer are caused. When the diffusion depth of boron is smaller than 0.5 µm, there is a risk of Ag piercing a PN junction region during metal electrode preparation. By using the junction depth of boron ranging from 0.5 µm to 1.0 µm, the present disclosure has advantages in both cell bifaciality and efficiency.

At S2, a BSG layer and a boron junction, each excluding its part corresponding to the first doped structure 2, are removed.

At S21, laser grooving is used to remove the BSG layer, excluding its part corresponding to the first doped structure 2.

One of the following manners may be adopted selectively in the laser grooving mentioned in the present disclosure. In an embodiment, ultraviolet picosecond laser is used to perform the laser grooving, with spot power ranging from 3 W to 20 W, a spot diameter ranging from 100 µm to 150 µm, a frequency ranging from 500 kHz to 600 kHz, and a scanning speed ranging from 40m/s to 80m/s. In another embodiment, green picosecond laser is used to perform the laser grooving, with spot power ranging from 5 W to 50 W, a spot diameter ranging from 100 µm to 500 µm, a frequency ranging from 500 kHz to 600 kHz, and a scanning speed ranging from 40 m/s to 80 m/s.

At S22, the boron junction, excluding its part corresponding to the first doped structure 2, is removed.

First, BSG layers on the front and side surface of the silicon substrate 1 are removed with an HF solution. In an embodiment, the operation at this step is completed in a chain-type machine.

In the present disclosure, when masking layers such as a BSG layer, a PSG layer, and a silicon oxide layer that are formed by rounding plating or deposition are removed, an HF solution with a volume concentration ranging from 5% to 20% or from 0.01 mol/L to 0.03 mol/L may be used, which is not described in detail again herein.

Then, polishing treatment is performed to remove the boron junction, excluding its part corresponding to the first doped structure 2, while removing a boron junction that has diffused onto the front surface of the silicon substrate 1. The boron junction and the BSG layer on the first doped structure 2 are both retained. In an embodiment, the operation at this step is completed in a groove-type machine.

When the boron junction, excluding its part corresponding to the first doped structure 2, is removed, the operation at this step also removes the BSG layers on the front and side surface of the silicon substrate 1 and the boron junction that has diffused on the front surface. The process is simple and lays a good foundation for subsequent process preparation.

At S3, the tunnel passivation contact structure and masking layer is formed on the back surface. A tunneling layer 31 and a phosphorus-doped amorphous silicon layer are grown on the entire back surface in a PECVD in-situ doping manner, and another masking layer is grown on the outermost surface. By alternately depositing a plurality of layers of tunneling layers 31 and a plurality of layers of phosphorus-doped amorphous silicon layers, a tunneling passivation contact structure including the plurality of layers of tunneling layers 31 and the plurality of layers of doped polysilicon layers 32 may be formed.

In an embodiment, the tunneling layer 31 is made of SiOx and has a thickness preferably ranging from 1.4 nm to 2.3 nm.

In another embodiment, the tunneling layer 31 is made of SiC, is denser, and has a thickness preferably ranging from 1 nm to 1.8 nm.

A thickness of an N-poly layer preferably ranges from 80 nm to 120 nm.

The masking layer is preferably a silicon oxide layer and has a thickness controlled to range from 10 nm to 50 nm.

At S4, a high-temperature annealing furnace is used, and an annealing temperature is matched according to a tunneling condition. The tunneling layer 31 has a large thickness and a high annealing temperature. In an embodiment, the annealing temperature ranges from 850°C to 950°C, which can achieve good matching with a conventional tunneling layer 31 and ensure that a doping concentration in electrochemical doping concentration testing (ECV testing) in an n-poly region ranges from 1E19 cm⁻³ to 1E21 cm⁻³.

During this process, the BSG layer is retained within the tunneling layer 31 of the first doped structure 2 (on the side adjacent to the silicon substrate), which obstructs diffusion of phosphorus into the silicon substrate 1. The phosphorus, excluding its part corresponding to the first doped structure 2, passes through the tunneling layer 31 and diffuses inwards to the silicon substrate 1 to form a phosphorus-doped region.

The annealing temperature is related to the denseness and thickness of the tunneling layer 31. In an embodiment, when the tunneling layer 31 is made of silicon oxide, the tunneling layer 31 has a thickness ranging from 1.4 nm to 2.3 nm and an annealing temperature ranging from 880°C to 950°C. When the tunneling layer 31 is a silicon carbide layer, the tunneling layer 31 has a thickness ranging from 1 nm to 1.8 nm and an annealing temperature ranging from 850°C to 900°C, to ensure that the phosphorus, excluding its part corresponding to the first doped structure 2, is diffused inwards to the silicon substrate 1.

At S5, the masking layer, the doped polysilicon layer 32, and the tunneling layer 31, each excluding its part corresponding to the second doped structure 3, are removed. The second doped structure 3 is spaced from the first doped structure 2.

At S51, the masking layer, excluding its part corresponding to the second doped structure 3, is removed using a laser process, to expose an underlying doped polysilicon layer 32. The laser parameters include: laser power ranging from 50W to 120W, preferably with the ultraviolet picosecond laser or green picosecond laser. The smaller the damage caused by the laser, the more beneficial it is to film-removing processing.

At S52, the HF solution is adopted to remove the masking layer diffused on the front surface due to wrap-round diffusion. This process is preferably operated in the chain-type machine.

At S53, the doped polysilicon layer 32 and tunneling layer 31, each excluding its part corresponding to the second doped structure 3 (the laser grooving region), on the back surface of the silicon substrate 1 are removed with a texturing alkaline solution. Meanwhile, the front surface of the silicon substrate 1 is etched with an alkaline solution to form a textured pyramid structure on the exposed silicon substrate 1, and finally cleaning is performed.

The groove-type machine is preferably used with the texturing alkaline solution to remove a P-type doped polysilicon layer diffused on the front surface of the silicon substrate 1, due to wrap-round diffusion and a P-type doped polysilicon layer on the laser grooving region on the back surface of the silicon substrate 1, forming the textured structure on the front surface of the silicon substrate 1 and the laser grooving region on the back surface of the silicon substrate 1.

The texturing alkaline solution used in the present disclosure is a commonly used texturing alkaline solution in the art, and may also be selected from a NaOH solution ranging from 0.2 mol/L to 0.5 mol/L or a KOH solution ranging from 0.2 mol/L to 0.5 mol/L.

In step S5, a film layer at a position where the second doped structure 3 is located and a film layer at a position where the isolation region 4 is located may also be removed in a patterned manner, so that a recess depth at the position where the second doped structure 3 is located and a recess depth at the position where the isolation region 4 is located are different.

Compared with the related art where "the textured structure is formed on the surface of the silicon substrate 1 before other film layers are prepared", the present disclosure forms a pyramid structure on the front surface of the silicon substrate 1 after important structures and film layers of the first doped structure 2 and the second doped structure 3 are prepared. On the one hand, polishing is not required to be performed on the back surface of the silicon substrate 1 before the boron diffusion. On the other hand, in step S53, a pyramid structure is formed on the front surface while the doped polysilicon layer 32 and tunneling layer 31 on the back surface are removed, achieving a plurality of objectives in one step. In addition, when the front surface of the silicon substrate 1 is flat, it is more beneficial to deposition and cleaning of the film layers in the operations at above steps.

In addition, the boron junction, tunneling layer 31, and doped polysilicon layer 32 between the first doped structure 2 and the second doped structure 3 are removed to form the isolation region 4, avoiding the occurrence of a leakage phenomenon between the first doped structure 2 and the second doped structure 3.

The width, depth, and the like of the isolation region 4 in the present disclosure are as described above and are not described in detail herein.

At S6, a passivation layer is formed on both sides, which is not a necessary process step.

In an embodiment, the passivation layers on the back and front surfaces are aluminum oxide layers. Aluminum oxide is deposited on both the front and back surfaces using an ALD process, and has a thickness preferably ranging from 3 nm to 6 nm. Al₂O₃ provides an excellent field passivation effect for the first doped structure 2 and an excellent interface passivation effect for the second doped structure 3.

In another embodiment, each of the passivation layers on the back and front surfaces includes the first charge film layer and the second charge film layer formed on the side of the first charge film layer facing away from the silicon substrate. The materials and thicknesses of the first charge film layer and the second charge film layer are as described above and are not described in detail herein.

The first charge film layer includes the silicon oxide film layer and the aluminum oxide film layer formed on the side of the silicon oxide film layer facing away from the silicon substrate. The deposition method includes, but is not limited to, the following types.

In an embodiment, deposition is performed using the ALD process. The silicon substrate is placed in an ALD device. First, water vapor is introduced into the ALD device, with a pulse time ranging from 5 s to 10 s and a processing cycle ranging from 3 cycles to 15 cycles, to form a silicon oxide layer with a thickness ranging from 0.5 nm to 2 nm. Subsequently, an aluminum oxide film layer is deposited by a conventional process and has a thickness ranging from 1 nm to 20 nm.

In another embodiment, a Plasma Enhanced Chemical Vapor Deposition (PECVD) method is employed to deposit an ultra-thin silicon oxide layer on the front surface at a temperature ranging from 200°C to 500°C, preferably from 350°C to 450°C.

In another embodiment, in an oxygen or air atmosphere, a high temperature process is used to form a silicon oxide layer on the surface of the silicon substrate at a temperature ranging from 300°C to 900°C, preferably ranging from 500°C to 600°C.

The second charge film layer includes a SiNx film layer or a SiOxNy film layer, and may be deposited using the PECVD method.

The passivation film layer on the front surface also includes a silicon oxide film layer, an aluminum oxide film layer, a SiNx film layer, or a SiOxNy film layer. The added silicon oxide film layer not only improves passivation effect on the front surface but also improves UV resistance performance of the solar cell, preventing the degradation of the passivation effect under sunlight irradiation, thereby improve the overall performance of the solar cell.

At S7, an anti-reflection layer is formed on both sides, which is not a necessary process step. Chemical vapor deposition is used to form a laminated film composed of one or more of silicon nitride, silicon oxynitride, or silicon is formed by. The thickness of the anti-reflection layer ranges from 60 nm to 130 nm.

At S8, electrodes are prepared. The electrodes are prepared by screen printing and sintering, which includes preparation of a back surface main grid electrode on the back surface and preparation of auxiliary grid electrodes for the first doped structure 2 and second doped structure 3 on the back surface.

At S9, laser sintering is performed on the first electrode 91 and the second electrode 92 using a laser-assisted sintering technology (LECO technology, also known as a laser-enhanced contact optimization technology). This can improve contact between silver and silicon in the electrodes, and thus can increase the cell efficiency by more than 0.2% to 0.3%. It also allows for the modification of an electrode paste, such as using a silver-coated copper paste with a lower silver content to save costs.

In the present disclosure, a laser wavelength used in the LECO technology is 1064 nm or 532 nm, and a laser width is 100 micrometers or ranges from 1mm to 2mm.

The present disclosure also provides a second method for fabricating a solar cell to form a solar cell shown in FIG. 9 to FIG. 11. In the solar cell shown in FIG. 9 to FIG. 11, the first doped structure 2 is an N-type diffusion region formed by phosphorus diffusion, and the second doped structure is a boron-doped P-type tunnel passivation contact structure. Moreover, the P-type tunnel passivation contact structure extends beyond the N-type diffusion region in a direction from the front surface to the back surface of the silicon substrate.

The second method for fabricating the solar cell includes the following steps.

At S1, silicon wafer processing is performed. An N-type silicon wafer with electrical resistivity ranging from 0.3Ω·cm to 7Ω·cm is selected for polishing or texturing.

For polishing, alkaline polishing is performed using KOH or NaOH and an additive. Alternatively, the surface of the silicon substrate 1 is textured, followed by polishing. After the polishing treatment, surfaces of the first doped structure 2 and the second doped structure 3 are planar, with a pyramid base width ranging from 15 µm to 30 µm.

For texturing, the texturing is performed on the surface of the silicon substrate 1, so that the surfaces of the first doped structure 2 and the second doped structure 3 are texture surfaces with a pyramid base width ranging from 3 µm to 15 µm.

At S2, a P-type tunnel passivation contact structure and a BSG layer are prepared on the entire back surface of the silicon substrate 1. A tunneling layer and an intrinsic silicon layer (i-Poly) are alternately deposited at least once. Boron diffusion is performed on the i-Poly using BCl₃ or BBr₃ as a diffusion source at a diffusion temperature ranging from 850°C to 960°C, to form a P-type doped polysilicon layer and form the BSG layer on the surface.

At S21, the tunneling layer/i-Poly is deposited using a LPCVD process. One tunneling layer 31 with a thickness ranging from 1.2 nm to 2 nm is grown on the back surface. Next, one i-poly layer with a thickness ranging from 200 nm to 400 nm is grown.

The term "alternately at least once" means that 0, 1, 2, ..., or n tunneling layers may be grown between the i-poly layers. Specifically, after n alternations, (n-1) tunneling layers may be grown between the i-poly layers.

At S22, boron doping is performed. Boron doping is performed via tube diffusion with BCl₃ or BBr₃ as the diffusion source. This process is performed at a temperature controlled to range from 850°C to 960°C. The sheet resistance ranges from 50 ohm/sq to 500 ohm/sq and a surface concentration ranges from 1E18 cm⁻³ to 1E20 cm⁻³. A thickness of the BSG layer ranges from 30 nm to 200 nm.

At S3, the BSG layer and the P-type tunnel passivation contact structure, each excluding its part corresponding to the P region, are removed.

At S31, the BSG layer is removed. Laser grooving is used to remove the BSG layer, excluding its part corresponding to the P region on the back surface of the silicon substrate. Moreover, a position at an edge of the silicon substrate is a laser grooving region. A hydrofluoric acid (HF) solution is used to remove the BSG layers diffused on the front surface and a side surface due to wrap-round diffusion. Preferably, the HF solution is added in the chain-type machine to remove BSG layers on the front surface and the side surface of the silicon wafer.

At S32, the P-type tunnel passivation contact structure is removed.

A texturing alkaline solution is used to remove the P-type doped polysilicon layer in the laser grooving region on the back surface and P-type doped polysilicon layers diffused on the front surface and the side surface due to wrap-round diffusion, while forming textured pyramid bases in these regions.

A polishing alkaline solution may also be used to remove the P-type doped polysilicon layer in the laser grooving region on the back surface and the P-type doped polysilicon layers diffused on the front surface and the side surface due to wrap-round diffusion, while forming planar pyramid bases in these regions.

The polishing alkaline solution used in the present disclosure is selected from polishing alkaline solutions commonly used in the art, and may also be: a sodium hydroxide (NaOH) solution ranging from 0.2 mol/L to 0.5 mol/L, a potassium hydroxide (KOH) solution ranging from 0.2 mol/L to 0.5 mol/L, a tetramethylammonium hydroxide (TMAH) solution ranging from 0.4 mol/L to 0.8 mol/L, with a polishing time ranging from 100 s to 300 s.

At S4, an N-type diffusion region and a PSG layer are formed through diffusion in a region excluding the P region.

A high-temperature diffusion furnace is used to perform phosphorus diffusion in the region excluding the P region to form the N-type diffusion region and the PSG layer at a temperature ranging from 850°C to 950°C, which ensures that a ECV tested doping concentration of the N-type diffusion region ranges from 1E15 cm⁻³ to 1E22 cm⁻³, preferably from 1E20 cm⁻³ to 1E21 cm⁻³. This diffusion step may also be conducted on both sides of the silicon substrate 1. In this way, an n+ field is formed on the front surface, and an N+ field is formed in a N region on the back surface.

At S5, the PSG layer and the N-type diffusion region in a region excluding the N region are removed.

At S51, the PSG layer is removed. Laser grooving is used to remove the PSG layer, excluding its part corresponding to the N region (where the isolation region 4 is located). Moreover, a position at the edge of the silicon substrate 1 is the laser grooving region.

By setting the position at the edge of the silicon substrate 1 as the laser grooving region in the present disclosure, an isolation region 4 may be formed at the edge of the silicon substrate 1 to insulate the back surface from the side surface and front surface. In other embodiments, groove forming may be performed or be not performed at the edge of the silicon substrate 1 in all laser grooving operations, both of which can achieve the insulation of the back surface from the side surface and the front surface.

At S52, the N-type diffusion region in the laser grooving region is removed.

The N-type diffusion region in the laser grooving region is removed using the polishing alkaline solution, and an isolation region 4 with a planar pyramid base is formed between the P region and the N region.

Specifically, the polishing alkaline solution is added in a groove-type machine for polishing treatment to remove the N-type diffusion region in the laser grooving region on the back surface and form a planar surface in the isolation region 4. A surface of the isolation region 4 facing towards the front surface of the silicon substrate 1 is planar, with a planar pyramid base width ranging from 15 µm to 30 µm or surface roughness smaller than or equal to 10 nm.

In this step, the front surface and the N region on the back surface are protected using the PSG layer as a mask, and the P region on the back surface is protected using the BSG layer as a mask, preventing the damage to the corresponding poly layer.

Alternatively, the polishing alkaline solution is replaced with the texturing alkaline solution, to remove the N-type diffusion region in the laser grooving region and form the isolation region 4 with the planar pyramid base between the P region and the N region.

In addition, before polishing or texturing is performed, the PSG layer on a side surface may also be removed by adding the HF solution in the chain-type machine. Therefore, the N-type diffusion region diffused on the side surface due to wrap-round diffusion is removed simultaneously during the polishing or texturing.

Finally, the HF solution is used for cleaning to remove the BSG layer in the P region and the PSG layer in the N region.

At S8, a passivation layer is formed on both sides, and reference is made to S6 in the first method for fabricating the solar cell.

At S9, an anti-reflection layer is formed on both sides, and reference is made to S7 in the first method for fabricating the solar cell.

At S10, electrodes are prepared. The electrodes are prepared by screen printing and sintering, which includes preparation of a back surface main grid electrode on the back surface and preparation of auxiliary grid electrodes for a P-type tunnel passivation contact structure and N-type doped structure 3 on the back surface.

At S11, laser sintering is performed on the first electrode 91 and the second electrode 92 using the LECO technology, and reference is made to S9 in the first method for fabricating the solar cell.

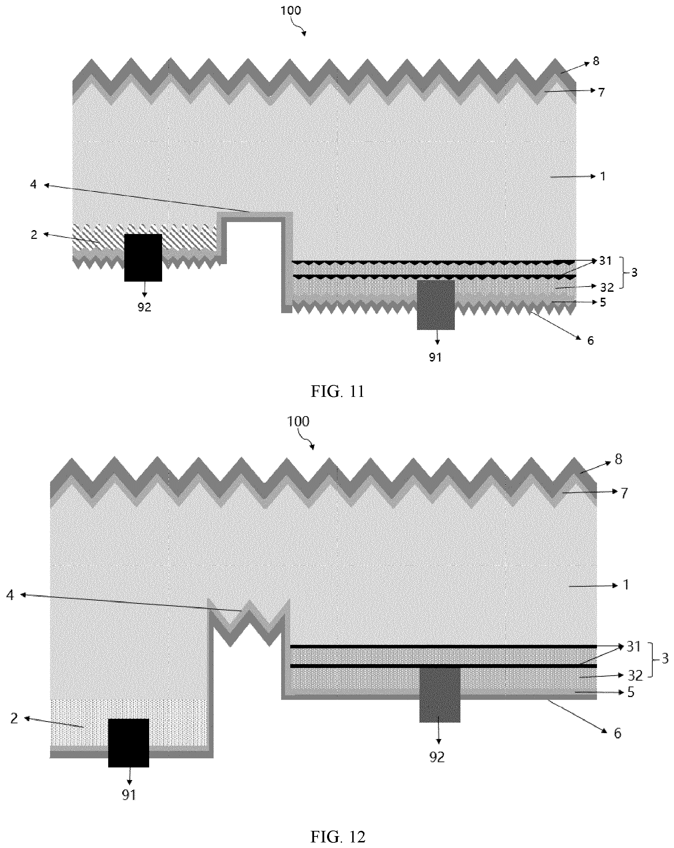

The present disclosure also provides a third method for fabricating a solar cell to form a solar cell shown in FIG. 12 to FIG. 14. In the solar cell shown in FIG. 12 to FIG. 14, the first doped structure 2 is an N-type diffusion region formed by phosphorus diffusion, the second doped structure is a boron-doped P-type tunnel passivation contact structure, and the N-type diffusion region extends beyond the P-type tunnel passivation contact structure in a direction from the front surface to the back surface of the silicon substrate.

The third method for fabricating the solar cell includes the following steps.

At S1, a polishing treatment is performed. An N-type silicon wafer is selected for use, and alkaline polishing is performed using KOH or NaOH and an additive. Alternatively, the surface of the silicon substrate 1 is textured, followed by polishing. A pyramid base width in a region where the P-type tunnel passivation contact structure is located ranges from 3 µm to 15 µm.

At S2, an N-type diffusion region (phosphorus junction) and a PSG layer are formed by phosphorus diffusion.

A high-temperature diffusion furnace is used to perform phosphorus diffusion on the entire back surface to form the N-type diffusion region and the PSG layer at a diffusion temperature ranging from 850°C to 950°C, ensuring that a ECV tested doping concentration of the N-type diffusion region ranges from 1E15 cm⁻³ to 1E22 cm⁻³, preferably from 1E20 cm⁻³ to 1E21 cm⁻³.

In an embodiment, the phosphorus diffusion is performed on the front surface of the silicon substrate 1, while performing the phosphorus diffusion on the back surface to form an N+ field on the front surface of the silicon substrate 1.

At S3, the PSG layer and phosphorus junction, each excluding its part corresponding to the first doped structure 2 on the back surface (N region), are removed.

At S31, laser grooving is performed in the region excluding the first doped structure 2 to remove the PSG layer excluding its part corresponding to the first doped structure 2.

At S32, the phosphorus junction, excluding its part corresponding to the first doped structure 2 is removed.

A PSG layer on a side surface of the silicon substrate 1 is removed, preferably by an etching process with an HF solution coated to the side surface or by a laser process.

Then, the polishing treatment is performed to remove the phosphorus junction, excluding its part corresponding to the first doped structure 2 on the back surface, while removing any phosphorus junction diffused on the side surface due to wrap-round diffusion. The phosphorus diffusion layer on the front surface, the phosphorus junction of the first doped structure 2, and the BSG layer are all retained. This step is preferably completed in a groove-type machine.

At S4, the P-type tunnel passivation contact structure is prepared.

At S41, a tunneling layer/i-Poly is formed using a LPCVD process. One tunneling layer 31 with a thickness ranging from 1.2 nm to 2 nm is grown on the back surface. Subsequently, one i-poly layer with a thickness ranging from 200 nm to 400 nm is grown. 0, 1, 2, ..., or n tunneling layers 31 may be grown between poly layers.

At S42, boron doping is performed. Boron doping may be performed via tube diffusion with BCl₃ or BBr₃ as a diffusion source. This process is performed at a temperature controlled to range from 850°C to 1100°C, preferably from 850°C to 960°C. Boron diffusion is performed on an intrinsic layer to form a P-type doped polysilicon layer, and a BSG layer is formed on the surface.

The P-type doped polysilicon layer has sheet resistance ranging from 50 ohm/sq to 500 ohm/sq and a surface concentration ranging from 1E18 cm⁻³ to 1E20 cm⁻³, and a thickness of the BSG layer ranges from 30 nm to 200 nm.

At S5, a BSG layer and a P-type passivation contact structure, each excluding its part corresponding to the second doped structure 3, are removed.

At S51, laser grooving is performed to remove the BSG layer, excluding its part corresponding to the second doped structure 3, to expose an underlying doped polysilicon layer 32.

At S52, BSG layers on the front surface and the side surface of the silicon wafer are removed using the chain-type machine and the HF solution.

At S53, the P-type passivation contact structure is removed.

In an embodiment, the doped polysilicon layer 32 diffused on the front surface of the silicon substrate 1 due to wrap-round diffusion and the doped polysilicon layer 32 in the laser grooving region on the back surface are removed using the groove-type machine with a texturing alkaline solution. Simultaneously, the front surface of the silicon substrate 1 is etched with the alkaline solution to form a pyramid structure on the exposed silicon substrate 1. At this point, the surface of the isolation region 4 is also a textured structure.

In another embodiment, the polishing alkaline solution is used to remove the P-type doped polysilicon layer in the laser grooving region, the P-type doped polysilicon layer on the front surface, and the P-type doped polysilicon layer on the side surface, and form a planar pyramid base. Then, a back surface masking layer is formed on the back surface, and is a silicon oxide layer with a thickness ranging from 30 nm to 100 nm. Under the protection of the back surface masking layer, the polishing alkaline solution is replaced with the texturing alkaline solution to form a textured pyramid base on the front surface of the silicon substrate 1 to improve front surface light-limiting performance. Finally, the back surface masking layer on the back surface is removed using a hydrofluoric acid solution.

At S6, a passivation layer is formed on both sides, and reference is made to S6 in the first method for fabricating the solar cell.

At S7, an anti-reflection layer is formed on both sides, and reference is made to S7 in the first method for fabricating the solar cell.

At S8, electrodes are prepared. The electrodes are prepared by screen printing and sintering, which includes preparation of a main grid electrode on the back surface and preparation of auxiliary grid electrodes for the P-type tunnel passivation contact structure and an N-type doped structure 3 on the back surface.

At S9, laser sintering is performed on the first electrode 91 and the second electrode 92 using a LECO technology, and reference is made to S9 in the first method for fabricating the solar cell. In summary, in the solar cell 100 of the present disclosure, by disposing both the first electrode 91 and the second electrode 92 on the back surface, there is no metal electrode obscuration on the front surface, maximizing the large light-receiving area of the solar cell and improving the high light conversion efficiency of the solar cell, and thus improving the cell efficiency. Moreover, by setting an SE structure in the first doped structure 2, the open-circuit voltage and the short-circuit current of the solar cell are improved. By setting the passivation contact structure in the second doped structure 3 to passivate the surface of the second doped structure 3, the short-circuit current of the solar cell is improved, thereby overall improving the cell efficiency.

It should be understood that, although the specification is described in accordance with the embodiments, not each embodiment contains only one independent technical solution. The specification is described in this manner only for the sake of clarity. Those skilled in the art should consider the specification as a whole. Also, the technical solutions in different embodiments can be combined appropriately to form other embodiments that can be understood by those skilled in the art.

The detailed descriptions set forth above are merely specific explanations for feasible embodiments of the present disclosure and are not intended to limit the scope of protection of the present disclosure. Any equivalent implementations or modifications made without departing from the spirit of the present disclosure shall fall within the scope of protection of the present disclosure.

## Claims

1. A solar cell, comprising:
a silicon substrate having a front surface and a back surface that face away from each other, the back surface of the silicon substrate having a first region, a second region, and an isolation region located between the first region and the second region;
a first doped structure disposed in the first region of the back surface, the first doped structure being a diffusion region formed by diffusing a dopant from the back surface into the silicon substrate;
a second doped structure disposed in the second region of the back surface, the second doped structure being a tunnel passivation contact structure, the tunnel passivation contact structure containing impurities of a conductive type opposite to that of the diffusion region;
a first electrode disposed at a back surface of the first doped structure; and
a second electrode disposed at a back surface of the second doped structure.

2. The solar cell according to claim 1, wherein:
the back surface of the silicon substrate in the second region is recessed towards the front surface of the silicon substrate with respect to the back surface of the silicon substrate in the first region;
the back surface of the silicon substrate in the isolation region is recessed towards the front surface of the silicon substrate with respect to the back surface of the silicon substrate in the first region;
a recess depth of the back surface of the silicon substrate in the second region recessed towards the front surface of the silicon substrate and/or a recess depth of the back surface of the silicon substrate in the isolation region recessed towards the front surface of the silicon substrate is greater than or equal to a diffusion depth of the diffusion region.

3. The solar cell according to claim 1, wherein:
a width of the isolation region ranges from 10 µm to 150 µm; and/or
a distance from the back surface of the silicon substrate in the isolation region to the back surface of the first doped structure ranges from 1 µm to 20 µm.

4. The solar cell according to claim 1, wherein:
a distance from the back surface of the second doped structure to the front surface of the silicon substrate is smaller than or equal to a distance from the back surface of the first doped structure to the front surface of the silicon substrate; or
a size of the second doped structure in a thickness direction of the silicon substrate is smaller than or equal to a recess depth of the isolation region; or
a distance, in the thickness direction of the silicon substrate, from the back surface of the first doped structure to the back surface of the second doped structure ranges from 1 µm to 10 µm.

5. The solar cell according to claim 1, wherein the first doped structure comprises a grid line region and a non-grid line region, wherein:
a doping concentration of the grid line region is greater than a doping concentration of the non-grid line region, the first electrode being in contact with the grid line region; and
preferably, sheet resistance of the grid line region ranges from 80 ohm/sq to 130 ohm/sq, and sheet resistance of the non-grid line region ranges from 200 ohm/sq to 400 ohm/sq.

6. The solar cell according to claim 1, wherein the tunnel passivation contact structure comprises:
at least one tunneling layer; and
at least one doped polysilicon layer each disposed on a side of one of the at least one tunneling layer facing away from the silicon substrate, the second electrode being in contact with the doped polysilicon layer.

7. The solar cell according to claim 6, wherein the at least one tunneling layer comprises n tunneling layers, and wherein the at least one doped polysilicon layer comprises n doped polysilicon layers, where n≥2, each of the n doped polysilicon layers being disposed on a side of a corresponding one of the n tunneling layers facing away from the silicon substrate,
wherein the second electrode is in contact with at least one of the 2-nd to n-th doped polysilicon layers, in a direction from the front surface to the back surface of the silicon substrate, of the n doped polysilicon layers.

8. The solar cell according to any one of claims 1 to 7, wherein the tunnel passivation contact structure comprises a tunneling layer and a doped polysilicon layer formed on a side of the tunneling layer facing away from the silicon substrate, wherein:
the first doped structure is a P-type diffusion region, and the doped polysilicon layer is an N-type doped polysilicon layer; or
the first doped structure is an N-type diffusion region, and the doped polysilicon layer is a P-type doped polysilicon layer.

9. The solar cell according to claim 1, wherein:
in a direction from the front surface to the back surface of the silicon substrate, a height of the first doped structure is greater than a height of the second doped structure; and
preferably, a height difference between the back surface of the first doped structure and the back surface of the second doped structure ranges from 0.5 to 1.5 times a diffusion depth of the diffusion region.

10. The solar cell according to claim 1, wherein:
a size of the back surface of the silicon substrate in the isolation region ranges from 15 µm to 30 µm; or
a roughness of the back surface of the silicon substrate in the isolation region is smaller than or equal to 10 nm.

11. The solar cell according to claim 1, further comprising a passivation film layer, wherein the passivation film layer in the isolation region comprises a first charge film layer in contact with the silicon substrate and a second charge film layer formed on a side of the first charge film layer facing away from the silicon substrate, wherein:
the first charge film layer and the silicon substrate are of the same charge type; and
the first charge film layer and the second charge film layer are of opposite charge types.

12. The solar cell according to claim 11, wherein a thickness of the first charge film layer is smaller than a thickness of the second charge film layer.

13. The solar cell according to claim 11, wherein:
the silicon substrate is of N-type silicon, the first charge film layer is a negative charge film layer, and the second charge film layer is a positive charge film layer; or
the silicon substrate is of P-type silicon, the first charge film layer is a positive charge film layer, and the second charge film layer is a negative charge film layer.

14. The solar cell according to claim 13, wherein:
the negative charge film layer comprises a silicon oxide film layer in contact with the silicon substrate and an aluminum oxide film layer formed on a side of the silicon oxide film layer facing away from the silicon substrate; and/or
the positive charge film layer is selected from at least one of a SiNx film layer or a SiOxNy film layer.

15. The solar cell according to claim 14, wherein:
a thickness of the silicon oxide film layer ranges from 0.5 nm to 2 nm, and a thickness of the aluminum oxide film layer ranges from 1 nm to 20 nm; and/or
a thickness of the positive charge film layer ranges from 10 nm to 100 nm.
